# FASCICULE DE BREVET EUROPEEN

(11) **EP 2 911 974 B1**
(45) Date de publication et mention de la délivrance du brevet: **31.08.2016**
(21) Numéro de dépôt: 13815015.6
(22) Date de dépôt: 25.10.2013
(51) Int. Cl.: B82Y 40/00, H01L 33/00, H01L 33/18, H01L 33/20, H01L 31/0352, H01L 31/036, H01L 21/205, H01L 33/08, H01L 33/24, H01L 33/28, H01L 33/32, H01L 33/38, H01L 31/0296, H01L 31/0304, H01L 21/203

(54) **DISPOSITIF OPTOÉLECTRONIQUE ET SON PROCÉDÉ DE FABRICATION**
OPTOELEKTRONISCHE VORRICHTUNG UND HERSTELLUNGSVERFAHREN DAFÜR
OPTOELECTRONIC DEVICE AND METHOD FOR MANUFACTURING THE SAME

(30) Priorité: 26.10.2012 FR 1260232; 28.03.2013 FR 1352794
(43) Date de publication de la demande: 02.09.2015
(73) Titulaire: Aledia, 38040 Grenoble Cedex (FR); Commissariat à l'Energie Atomique et aux Energies Alternatives, 75015 Paris (FR)
(72) Inventeur: DECHOUX, Nathalie, 38430 Moirans (FR); AMSTATT, Benoît, F-38000 Grenoble (FR); GILET, Philippe, F-38470 Teche (FR)
(74) Mandataire: Thibon, Laurent
(86) Numéro de dépôt international: PCT/FR2013/052551
(87) Numéro de publication internationale: WO 2014/064395

(56) Documents cités:
- WO-A1-2009/072631
- WO-A1-2012/136665
- US-A1- 2007 217 460
- US-A1- 2008 093 622
- US-A1- 2010 148 149
- US-A1- 2011 140 072
- US-A1- 2012 001 303
- US-A1- 2012 211 759
- CHEN X ET AL: "Homoepitaxial growth of catalyst-free GaN wires on N-polar substrates", APPLIED PHYSICS LETTERS, AIP, AMERICAN INSTITUTE OF PHYSICS, MELVILLE, NY, US, vol. 97, no. 15, 13 octobre 2010 (2010-10-13), pages 151909-151909, XP012137241, ISSN: 0003-6951, DOI: 10.1063/1.3497078

## Description

### Domaine

La présente invention concerne de façon générale les matériaux semiconducteurs, les dispositifs optoélectroniques à base de matériaux semiconducteurs et leurs procédés de fabrication. La présente invention concerne plus particulièrement les dispositifs optoélectroniques comprenant des éléments tridimensionnels, notamment des microfils ou nanofils semiconducteurs.

### Exposé de l'art antérieur

Le document WO 2009/072631 A1 décrit un dispositif émetteur de lumière et son procédé de fabrication. Ce dispositif comprend des éléments tridimensionnels à base de semiconducteurs en nitrures du groupe III. Ces éléments sont directement formés sur une couche germe en nitrure d'aluminium (APN) laquelle remplit des ouvertures dans un masque en SiO₂ déposé sur le substrat.

Le document US 2012/0001303 A1 décrit un ensemble de dispositifs émetteurs de lumière, des diodes électroluminescentes en l'occurrence, sur un substrat commun. Les diodes y sont formées directement sur des bandes en matériau germe, typiquement en APN; ces bandes étant séparées les unes des autres par des tranchées qui exposent la surface du substrat. Cette surface exposée est convertie, dans sa profondeur, en un matériau (Si₃N₄ par exemple) ne permettant justement pas la croissance verticale desdites diodes dessus.

Des exemples de microfils ou nanofils comprenant un matériau semiconducteur sont les microfils ou nanofils à base d'un composé comportant majoritairement au moins un élément du groupe III et un élément du groupe V (par exemple du nitrure de gallium GaN), appelé par la suite composé III-V, ou comportant majoritairement au moins un élément du groupe II et un élément du groupe VI (par exemple de l'oxyde de zinc ZnO), appelé par la suite composé II-VI. De tels microfils ou nanofils permettent la fabrication de dispositifs semiconducteurs tels que des dispositifs optoélectroniques. Par dispositifs optoélectroniques, on entend des dispositifs adaptés pour effectuer la conversion d'un signal électrique en un rayonnement électromagnétique ou inversement, et notamment des dispositifs dédiés à la détection, la mesure ou l'émission d'un rayonnement électromagnétique ou des dispositifs dédiés aux applications photovoltaïques.

Les procédés de fabrication de microfils ou de nanofils à matériau semiconducteur doivent permettre la fabrication des microfils ou des nanofils avec un contrôle précis et uniforme de la géométrie, de la position et des propriétés cristallographiques de chaque microfil ou nanofil.

Le document US 7 829 443 B2 décrit un procédé de fabrication de nanofils comprenant le dépôt d'une couche en un matériau diélectrique sur une face plane d'un substrat, la gravure d'ouvertures dans la couche du matériau diélectrique pour exposer des portions du substrat, le remplissage des ouvertures de portions d'un matériau favorisant la croissance de nanofils et la formation des nanofils dans les ouvertures sur ces portions. Le matériau diélectrique est choisi de façon que les nanofils ne croissent pas directement sur celui-ci.

Pour que les propriétés de conversion d'un signal électrique en un rayonnement électromagnétique ou inversement des microfils ou nanofils soient les meilleures possibles, il est souhaitable que chaque microfil ou nanofil ait une structure sensiblement monocristalline. En particulier, lorsque les microfils ou nanofils sont majoritairement composés d'un matériau à base d'un premier élément et d'un deuxième élément, par exemple des composés III-V ou II-VI, il est souhaitable que chaque microfil ou nanofil ait sensiblement une polarité constante sur la totalité du microfil ou nanofil.

Toutefois, avec le procédé décrit dans le document US 7 829 443 B2, la croissance des nanofils peut être perturbée de sorte que chaque nanofil peut ne pas avoir une structure monocristalline. En particulier, lorsque les nanofils sont majoritairement composés d'un matériau à base d'un premier élément et d'un deuxième élément, par exemple des composés III-V ou II-VI, il peut apparaître, sur les flancs du nanofils, une couche périphérique ayant une polarité inversée par rapport à la polarité au coeur du nanofil.

Ceci peut entraîner la formation de défauts, notamment au niveau des joints de grains, qui peuvent dégrader le rendement de la conversion d'un signal électrique en un rayonnement électromagnétique ou inversement.

### Résumé

Ainsi, un objet d'un mode de réalisation est de pallier au moins en partie les inconvénients des dispositifs optoélectroniques, notamment à microfils ou nanofils, et de leurs procédés de fabrication décrits précédemment.

Un autre objet d'un mode de réalisation est que les éléments tridimensionnels, notamment des microfils ou nanofils, en matériau semiconducteur ne soient pas formés au travers d'ouvertures réalisées dans une couche d'un matériau diélectrique.

Un autre objet d'un mode de réalisation est que chaque élément tridimensionnel, notamment chaque microfil ou nanofil, en matériau semiconducteur ait sensiblement une structure monocristalline.

Un autre objet d'un mode de réalisation est que la position, la géométrie et les propriétés cristallographiques de chaque élément tridimensionnel, notamment chaque microfil ou nanofil, en matériau semiconducteur puissent être contrôlées de façon précise et uniforme.

Un autre objet d'un mode de réalisation est que les éléments tridimensionnels, notamment les microfils ou nanofils, en matériau semiconducteur puissent être formés à une échelle industrielle et à bas coût.

Ainsi, conformément à la présente invention, un mode de réalisation prévoit un dispositif optoélectronique, comprenant :
un substrat ;
des plots sur une face du substrat ;
des éléments semiconducteurs, chaque élément reposant sur un plot ;
une portion recouvrant au moins les flancs latéraux de chaque plot, ladite portion empêchant la croissance des éléments semiconducteurs sur les flancs latéraux ; et,
en outre, une région diélectrique s'étendant dans le substrat depuis ladite face et reliant, pour chaque paire de plots, l'un des plots de la paire à l'autre plot de la paire.

Selon un mode de réalisation, le substrat est en un premier matériau semiconducteur choisi parmi le groupe comprenant le silicium, le germanium, le carbure de silicium, un composé III-V, un composé II-VI et une combinaison de ces composés.

Selon un mode de réalisation, chaque élément comprend au moins une partie comprenant majoritairement un deuxième matériau semiconducteur en contact avec l'un des plots, le deuxième matériau semiconducteur étant choisi parmi le groupe comprenant le silicium, le germanium, le carbure de silicium, un composé III-V, un composé II-VI et une combinaison de ces composés.

Selon un mode de réalisation, l'épaisseur de chaque plot est comprise entre 1 nm et 100 nm et le substrat est en contact électrique avec chaque plot.

Selon un mode de réalisation, chaque élément semiconducteur est un microfil, un nanofil, un élément conique ou un élément tronconique.

Un mode de réalisation prévoit également conformément à la présente invention, un procédé de fabrication d'un dispositif optoélectronique, comprenant les étapes successives suivantes :
prévoir un substrat ;
former des plots sur une face du substrat ;
former une portion recouvrant au moins les flancs latéraux de chaque plot et former une région diélectrique s'étendant dans le substrat depuis ladite face et reliant, pour chaque paire de plots, l'un des plots de la paire à l'autre plot de la paire; et
former des éléments semiconducteurs, chaque élément reposant sur un plot, ladite portion comprenant un matériau empêchant la croissance des éléments semiconducteurs sur les flancs latéraux.

Selon un mode de réalisation, la portion est en un matériau isolant.

Selon un mode de réalisation, la région diélectrique est formée par oxydation ou nitruration du substrat.

Selon un mode de réalisation, le procédé comprend les étapes successives suivantes :
dépôt d'une couche sur le substrat ;
formation de blocs isolants sur la couche ;
gravure des parties de la couche non recouvertes des blocs isolants pour former les plots ;
oxydation des flancs des plots et des parties du substrat non recouvertes des plots ; et
retrait des blocs isolants.

Selon un mode de réalisation, le procédé comprend les étapes successives suivantes :
dépôt d'une couche sur le substrat ;
formation de blocs isolants sur la couche ;
gravure des parties de la couche non recouvertes des blocs isolants pour former les plots ;
retrait des blocs isolants ;
dépôt d'une couche diélectrique recouvrant les plots et le substrat entre les plots ;
gravure anisotrope de la couche diélectrique pour retirer la couche diélectrique sur le substrat et au sommet des plots et laisser les portions de la couche diélectrique sur les flancs latéraux ; et
nitruration des parties du substrat non recouvertes des plots, et éventuellement des sommets des plots.

### Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :
les figures 1A à 1C sont des coupes, partielles et schématiques, des structures obtenues à des étapes successives d'un procédé connu de fabrication d'un dispositif optoélectronique à microfils ou nanofils ;
la figure 2 est une coupe, partielle et schématique, de détail d'un microfil ou nanofil obtenu par le procédé décrit en relation avec les figures 1A à 1C ;
la figure 3 est une coupe, partielle et schématique, d'un mode de réalisation d'un dispositif optoélectronique à microfils ou nanofils conformément à la présente invention;
les figures 4A à 4I sont des coupes, partielles et schématiques, des structures obtenues à des étapes successives d'un mode de réalisation d'un procédé de fabrication, conforme à l'invention, du dispositif optoélectronique de la figure 3 ;
les figures 5A et 5B sont des coupes, partielles et schématiques, des structures obtenues à des étapes successives d'un autre mode de réalisation d'un procédé, conforme à l'invention, de fabrication du dispositif optoélectronique de la figure 3 ;
la figure 6 est une coupe, partielle et schématique, d'un autre mode de réalisation d'un dispositif optoélectronique à microfils ou nanofils ne faisant pas partie de la présente invention;
les figures 7A à 7D sont des coupes, partielles et schématiques, des structures obtenues à des étapes successives d'un mode de réalisation d'un procédé, non conforme à l'invention, de fabrication du dispositif optoélectronique de la figure 6 ;
la figure 8 est une coupe, partielle et schématique, d'un autre mode de réalisation d'un dispositif optoélectronique à microfils ou nanofils conformément à la présente invention, et
la figure 9 est une coupe, partielle et schématique, d'un mode de réalisation d'un dispositif optoélectronique à éléments tridimensionnels pyramidaux conformément également à l'invention.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs optoélectroniques décrits ci-après sont à la portée de l'homme de l'art et ne sont pas décrits.

Dans la suite de la description, sauf indication contraire, les termes "sensiblement", "environ" et "de l'ordre de" signifient "à 10 % près". En outre, on entend par "composé principalement constitué d'un matériau" ou "composé à base d'un matériau" qu'un composé comporte une proportion supérieure ou égale à 95 % dudit matériau, cette proportion étant préférentiellement supérieure à 99 %.

La présente invention concerne la fabrication d'éléments tridimensionnels, par exemple de microfils, de nanofils ou d'éléments en forme de pyramide. Dans la suite de la description, des modes de réalisation sont décrits pour la fabrication de microfils ou de nanofils. Toutefois, ces modes de réalisation peuvent être mis en oeuvre pour la fabrication d'éléments tridimensionnels autres que des microfils ou des nanofils, par exemple pour la fabrication d'éléments tridimensionnels en forme de pyramide.

Le terme "microfil" ou "nanofil" désigne une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil.

La section droite des fils peut avoir différentes formes, telles que, par exemple, une forme ovale, circulaire ou polygonale, notamment triangulaire, rectangulaire, carrée ou hexagonale. Ainsi, on comprend que, quand on mentionne ici le "diamètre" dans une section droite d'un fil ou d'une couche déposée sur ce fil, il s'agit d'une grandeur associée à la surface de la structure visée dans cette section droite, correspondant, par exemple, au diamètre du disque ayant la même surface que la section droite du fil.

Les fils peuvent être, au moins en partie, formés à partir d'au⁻ moins un matériau semiconducteur. Le matériau semiconducteur peut être du silicium, du germanium, du carbure de silicium, un composé III-V, un composé II-VI ou une combinaison de ces composés.

Les fils peuvent être, au moins en partie, formés à partir de matériaux semiconducteurs comportant majoritairement un composé III-V, par exemple des composés III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les fils peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn) et le cadmium (Cd). Des exemples d'éléments du groupe VI. comprennent des éléments du groupe VIA, notamment l'oxygène (O) et le tellure (Te). Des exemples de composés II-VI sont ZnO, ZnMgO, CdZnO ou CdZnMgO. De façon générale, les éléments dans le composé II-VI peuvent être combinés avec différentes fractions molaires.

Dans certains modes de réalisation, les fils peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du soufre (S), du terbium (Tb) ou de l'étain (Sn).

Les fils sont formés sur un substrat. Le substrat peut correspondre à une structure monobloc ou correspondre à une couche recouvrant un support constitué d'un autre matériau. Le substrat est, par exemple, un substrat semiconducteur, tel qu'un substrat en silicium, en germanium, en carbure de silicium, en un composé III-V, tel que du GaN ou du GaAs, ou un substrat en ZnO. Le substrat peut être en un matériau conducteur, par exemple en métal, ou en un matériau isolant, par exemple en saphir, en verre ou en céramique.

Le principe de l'invention est de former, sur une face d'un substrat, des plots ou îlots, appelés également par la suite îlots de germination, d'un matériau favorisant la croissance des fils et de réaliser ensuite un traitement de protection des flancs latéraux des îlots de germination et de la surface des parties du substrat non recouvertes par les îlots de germination pour former une région de protection impropre à la croissance de fils, par exemple une région diélectrique, sur les flancs latéraux des îlots de germination et s'étendant dans le substrat et reliant, pour chaque paire de plots, l'un des plots de la paire à l'autre plot de la paire, les fils ne croissant pas sur la région de protection.

Le fait de dire qu'un composé à base d'au moins un premier élément et d'un deuxième élément a une polarité du premier élément ou une polarité du deuxième élément signifie que le matériau croît selon une direction privilégiée et que lorsque le matériau est coupé dans un plan perpendiculaire à la direction de croissance privilégiée, la face exposée comprend essentiellement des atomes du premier élément dans le cas de la polarité du premier élément ou des atomes du deuxième élément dans le cas de la polarité du deuxième élément.

Le matériau constituant les îlots de germination est choisi de façon à favoriser la croissance du fil selon la même polarité. A titre d'exemple, lorsque les fils comprennent majoritairement un composé III-V, le matériau constituant les îlots de germination est choisi de préférence de façon à favoriser la croissance du composé III-V selon la polarité de l'élément du groupe V. Le composé III-V croît alors selon la polarité de l'élément du groupe V sur les îlots de germination, depuis le sommet de chaque îlot de germination, et ne croît ni sur les flancs latéraux des îlots de germination ni sur le reste du substrat. En outre, les inventeurs ont mis en évidence que chaque fil croît alors selon une polarité sensiblement constante dans la totalité du fil. Lorsque les fils comprennent majoritairement un composé II-VI, le matériau constituant les îlots de germination est choisi de préférence de façon à favoriser la croissance du composé II-VI selon la polarité de l'élément du groupe VI. Le composé II-VI croît alors selon la polarité de l'élément du groupe VI sur les îlots de germination, depuis le sommet de chaque îlot de germination, et ne croît ni sur les flancs latéraux des îlots de germination ni sur le reste du substrat.

Dans le cas d'un composé III-V dans lequel l'élément du groupe V est l'azote, le matériau composant les îlots peut être un matériau favorisant la croissance d'un fil selon la polarité N. A titre d'exemple, les îlots peuvent être réalisés en nitrure d'aluminium (AlN), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), en nitrure de magnésium sous la forme MgₓN_{y}, où x est environ égal à 3 et y est environ égal à 2, par exemple du nitrure de magnésium selon la forme Mg₃N₂ ou du nitrure de gallium et de magnésium (MgGaN), en tungstène (W), en nitrure de tungstène (WN), en platine (Pt), en nitrure de platine (PtN) ou en une combinaison de ceux-ci et de leurs composés nitrurés. De préférence, le matériau composant les îlots de germination est le nitrure d'aluminium.

Le procédé de croissance des fils peut être un procédé du type dépôt chimique en phase vapeur (CVD, sigle anglais pour Chemical Vapor Deposition) ou dépôt chimique en phase vapeur organométallique (MOCVD, acronyme anglais pour Metal-Organic Chemical Vapor Deposition), également connu sous le nom d'épitaxie organométallique en phase vapeur (ou MOVPE, acronyme anglais pour Metal-Organic Vapor Phase Epitaxy). Toutefois, des procédés tels que l'épitaxie par jets moléculaires (MBE, acronyme anglais pour Molecular-Beam Epitaxy), la MBE à source de gaz (GSMBE), la MBE organométallique (MOMBE), la MBE assistée par plasma (PAMBE), l'épitaxie par couche atomique (ALE, acronyme anglais pour Atomic Layer Epitaxy) ou l'épitaxie en phase vapeur aux hydrures (HVPE, acronyme anglais pour Hydride Vapor Phase Epitaxy) peuvent être utilisés. Toutefois, des procédés électrochimiques peuvent être utilisés, par exemple, le dépôt en bain chimique (CBD, sigle anglais pour Chemical Bath Deposition), les procédés hydrothermiques, la pyrolise d'aérosol liquide ou l'électrodépôt.

A titre d'exemple, le procédé peut comprendre l'injection dans un réacteur d'un précurseur d'un élément du groupe III et d'un précurseur d'un élément du groupe V. Des exemples de précurseurs d'éléments du groupe III sont le triméthylgallium (TMGa), le triéthylgallium (TEGa), le triméthylindium (TMIn) ou le triméthylaluminium (TMAl). Des exemples de précurseurs d'éléments du groupe V sont l'ammoniac (NH₃), le tertiarybutylphosphine (TBP), l'arsine (AsH₃), ou le diméthylhydrazine asymétrique (UDMH).

Selon un mode de réalisation de l'invention, dans une première phase de croissance des fils du composé III-V, un précurseur d'un élément supplémentaire est ajouté en excès en plus des précurseurs du composé III-V. L'élément supplémentaire peut être le silicium (Si). Un exemple de précurseur, du silicium est le silane (SiH₄).

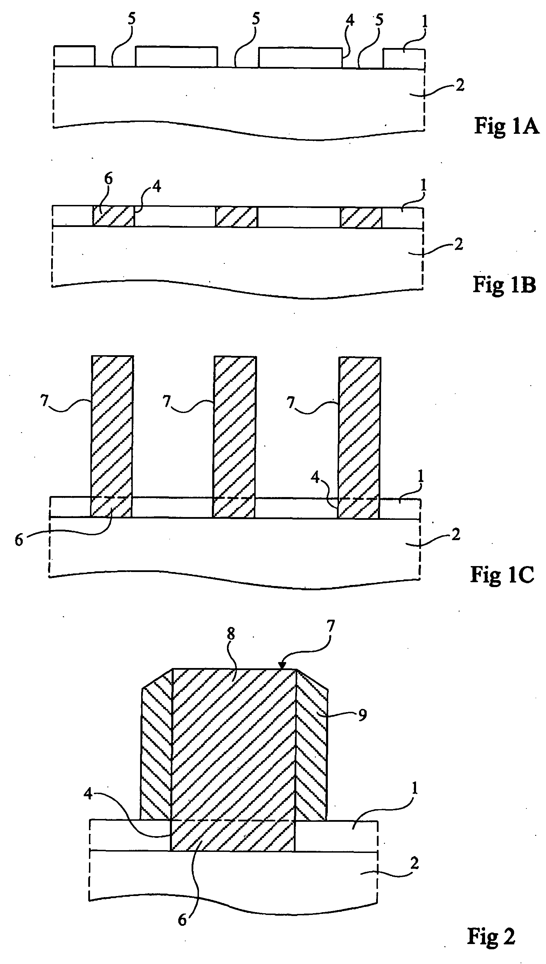

Les figures 1A à 1C illustrent les structures obtenues à des étapes successives d'un exemple de procédé connu de fabrication d'un dispositif optoélectronique à microfils ou nanofils.
(i) Une couche 1 d'un matériau diélectrique est déposée sur un substrat 2 et des ouvertures 4 sont gravées dans la couche 1, les ouvertures 4 venant exposer certaines parties 5 du substrat 2 (figure 1A).
(ii) On fait croître des portions 6 d'un matériau favorisant la croissance de fils dans les ouvertures 4 (figure 1B).
(iii) On fait croître un fil 7 sur chaque portion 6 (figure 1C).

La figure 2 est une vue de détail de l'un des fils 7 représenté en figure 1C.

Les inventeurs ont mis en évidence que lorsque le procédé décrit précédemment en relation avec les figures 1A à 1C est mis en oeuvre pour la formation de fils d'un matériau semiconducteur à base d'un composé d'un premier élément et d'un deuxième élément, ceci se traduit par la formation d'un fil 7 comprenant un coeur 8 monocristallin, ayant la polarité du premier élément, entouré d'une couche périphérique 9 monocristalline de la polarité du deuxième élément. Ceci peut entraîner l'apparition de défauts à l'interface entre la couche 9 et le coeur 8.

Une explication serait que la présence de la couche de diélectrique 1 perturbe la formation de la portion 6, ce qui entraîne la formation de la couche 9 lorsque le fil 7 croît à partir de la portion 6 sous-jacente.

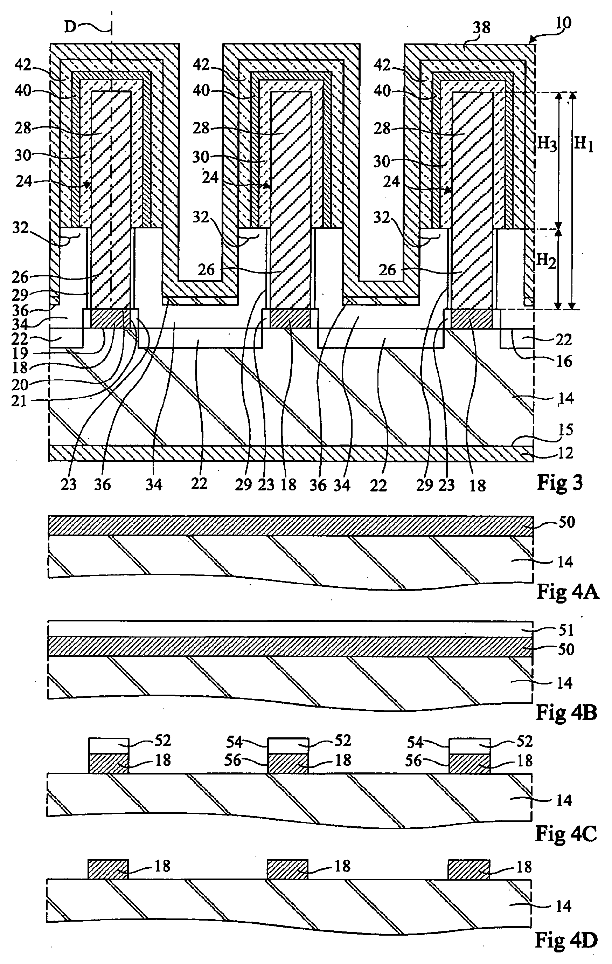

La figure 3 est une coupe, partielle et schématique, d'un mode de réalisation selon l'invention d'un dispositif optoélectronique 10 réalisé à partir de fils tels que décrits précédemment et adapté à l'émission d'un rayonnement électromagnétique.

Le dispositif 10 comprend, du bas vers le haut en figure 3 :
une première électrode de polarisation 12 ;
un substrat (par exemple semiconducteur) 14 comprenant des faces opposées 15 et 16, la face 15 étant au contact de l'électrode 12 ;
des îlots de germination 18 favorisant la croissance de fils et disposés sur la face 16, chaque îlot 18 comprenant une face inférieure 19 en contact avec la face 16 du substrat 14, une face supérieure 20, opposée à la face 19, et à distance de la face 19 et des faces latérales 21, ou flancs latéraux, reliant la face inférieure 19 à la face supérieure 20 ;
une région 22 dans le substrat 14, s'étendant entre chaque paire d'îlots 18 depuis la face 16 sur une partie de la profondeur du substrat 14, la région 22 étant constituée d'un diélectrique, issu de la transformation du substrat, qui protège le substrat sous-jacent et empêche la croissance de fils ;
des portions de protection 23, d'un matériau impropre à la croissance de fils, recouvrant les faces latérales 21 et entourant chaque îlot 18, les portions de protection 23 empêchant la croissance de fils ;
des fils 24 (trois fils étant représentés) de hauteur H₁, chaque fil 24 étant en contact avec la face 20 de l'un des îlots 18, chaque fil 24 comprenant une portion inférieure 26, de hauteur H₂, en contact avec l'îlot 18 et une portion supérieure 28, de hauteur H₃, en contact avec la portion inférieure 26 ;
une couche passivante 29 recouvrant la périphérie de chaque portion inférieure 26 ;
une couche active 30 recouvrant chaque portion supérieure 28 ;
une couche semiconductrice 32 ou davantage recouvrant chaque couche active 30 ;
des portions isolantes 34 recouvrant la face 16 entre les fils 24 et chaque fil 24 sur au moins la hauteur H₂ ;
une portion réfléchissante 36 recouvrant les portions isolantes 34 entre les fils 24 ; et
une couche de seconde électrode 38 recouvrant les couches semiconductrices 32 et les portions isolantes 34.

Le substrat 14 est, par exemple, un substrat semiconducteur, tel qu'un substrat en silicium. Le substrat 14 peut être dopé d'un premier type de conductivité, par exemple dopé de type N. Les faces 15 et 16 peuvent être planes et parallèles. La face 16 du substrat 14 peut être une face <100>.

L'électrode 12 peut correspondre à une couche conductrice qui s'étend sur la face 15 du substrat 14. Le matériau formant l'électrode 12 est, par exemple, du siliciure de nickel (NiSi), de l'aluminium (Al), du siliciure d'aluminium (AlSi), du titane (Ti) ou du siliciure de titane (TiSi). Cette couche peut être recouverte d'une autre couche métallique, par exemple de l'or, du cuivre ou des eutectiques (Ti/Ni/Au ou Sn/Ag/Cu) en cas de brasure.

Les îlots 18 ont, par exemple, une épaisseur comprise entre 1 et 100 nanomètres, de préférence comprise entre 10 et 60 nanomètres. Les îlots 18 sont situés sur la face 16 de sorte qu'ils soient en saillie par rapport à la face 16. Le sommet 20 de chaque îlot 18 est donc dans un plan différent de la face 16. Chaque îlot 18 a une texturation préférentielle et, lorsque le matériau composant chaque îlot comprend un alliage d'au moins deux éléments, une polarité préférentielle. Par texturation préférentielle, on entend que les cristaux qui composent lès îlots 18 ont une direction de croissance privilégiée qui est la même pour tous les îlots 18. Par polarité préférentielle, on entend que les îlots 18 ont sensiblement tous la même polarité. Ceci signifie que lorsque le matériau composant chaque îlot comprend un alliage d'au moins deux éléments, lorsque le matériau est coupé dans un plan perpendiculaire à la direction de croissance privilégiée du matériau, la surface exposée comprend essentiellement des atomes du même élément pour chaque îlot 18. Chaque îlot 18 peut présenter le même type de conductivité que le substrat 14 afin de limiter la résistance d'interface entre les îlots 18 et le substrat 14. Chaque îlot 18 peut avoir une forme quelconque, par exemple rectangulaire, polygonale, circulaire, carrée ou ovale. De préférence, le diamètre moyen de l'îlot de germination 18 est du même ordre de grandeur que le diamètre moyen du fil 20 destiné à croître sur l'îlot de germination 18.

Les portions de protection 23 peuvent être constituées d'un matériau déposé sur les flancs 21 des îlots de germination 18. Il peut s'agir de matériaux déposés de façon conforme, par exemple par CVD. Il s'agit, par exemple, d'oxyde de silicium (SiO₂), de nitrure de silicium (SiₓN_{y}, où x est environ égal à 3 et y est environ égal à 4, par exemple du Si₃N₄), d'oxyde d'aluminium (Al₂O₃), d'oxyde d'hafnium (HfO₂) ou de diamant. Les portions de protection 23 peuvent, en outre, être constituées d'un matériau diélectrique issu de la transformation du matériau constituant les îlots de germination 18. Le matériau constituant les portions de protection 23 peut alors correspondre à un oxyde des exemples de matériaux des îlots de germination 18 décrits précédemment. A titre d'exemple, l'épaisseur des portions isolantes 23 est comprise entre 5 nm et 100 nm, par exemple égale à environ 30 nm.

Les régions 22 peuvent s'étendre en partie sous les îlots 18. La région 22 peut s'étendre partiellement sous certains îlots 18 ou sous chaque îlot 18. Toutefois, le substrat semiconducteur 14 doit rester en contact électrique avec chaque îlot 18. Les conditions de formation des régions 22 sont donc choisies de façon que les régions 22 s'étendent au plus sur une longueur inférieure à la moitié de la plus grande longueur de la section du fil. A titre d'exemple, la profondeur de chaque région 22 est comprise entre 5 nm et 100 nm, par exemple 10 nm.

Les centres de deux îlots 18 adjacents peuvent être distants de 0,5 µm à 10 µm et de préférence de 1,5 à 4 µm. A titre d'exemple, les îlots 18 peuvent être régulièrement répartis sur le substrat 14, la région 22 formant un quadrillage entourant chaque îlot 18. A titre d'exemple, les îlots 18 peuvent être répartis selon un réseau hexagonal.

Chaque fil 24 est une structure semiconductrice allongée selon un axe D sensiblement perpendiculaire à la face 16. Chaque fil 24 peut avoir une forme générale cylindrique allongée à base hexagonale. Le diamètre moyen de chaque fil 24 peut être compris entre 50 nm et 2,5 µm et la hauteur H₁ de chaque fil 24 peut être comprise entre 250 nm et 50 µm.

La portion inférieure 26 de chaque fil 24 est principalement constituée du composé III-N, par exemple du nitrure de gallium, dopé d'un premier type de conductivité; par exemple au silicium. Le pourtour de la portion inférieure 26 est recouvert par la couche 29 de diélectrique, par exemple du SiN, sur la hauteur H₂ depuis l'extrémité de la portion inférieure 26 au contact avec l'îlot 18 associé. La hauteur H₂ peut être comprise entre 100 nm et 25 µm. La couche de matériau diélectrique 29 a une épaisseur comprise entre une monocouche atomique et 100 nm, de préférence entre une monocouche atomique et 10 nm.

La portion supérieure 28 de chaque fil 24 est, par exemple, au moins partiellement réalisée dans un composé III-N, par exemple du GaN. La portion supérieure 28 peut être dopée du premier type de conductivité, par exemple de type N, ou ne pas être intentionnellement dopée. La portion supérieure 28 s'étend sur la hauteur H₃ qui peut être comprise entre 100 nm et 25 µm.

Dans le cas d'un fil composé principalement de GaN, la structure cristalline du fil peut être du type wurtzite, le fil s'étendant selon l'axe C. La structure cristalline du fil peut également être du type cubique.

La couche active 30 est la couche depuis laquelle est émise la majorité du rayonnement fourni par le dispositif 10. Selon un exemple, la couche active 30 peut comporter des moyens de confinement, tels que des puits quantiques multiples. Elle est, par exemple, constituée d'une alternance de couches de GaN et de InGaN ayant des épaisseurs respectives de 5 à 20 nm (par exemple 8 nm) et de 1 à 10 nm (par exemple 2,5 nm). Les couches de GaN peuvent être dopées, par exemple de type N ou P. Selon un autre exemple, la couche active peut comprendre une seule couche d'InGaN, par exemple d'épaisseur supérieure à 10 nm.

La couche semiconductrice 32 permet la formation d'une jonction P-N ou P-I-N avec la couche active 30 et/ou la portion supérieure 28. Elle permet l'injection de trous dans la couche active 30 via l'électrode 38.

L'empilement de couches semiconductrices 32 peut comprendre une couche de blocage d'électrons 40 formée d'un alliage ternaire, par exemple en nitrure de gallium et d'aluminium (AlGaN) ou en nitrure d'indium et d'aluminium (AlInN) en contact avec la couche active 30 et une couche supplémentaire 42, pour assurer un bon contact électrique entre la deuxième électrode 38 et la couche active 30, par exemple en nitrure de gallium (GaN) en contact avec la couche de blocage d'électrons 40 et avec l'électrode 38. La couche semiconductrice 42 est dopée du type de conductivité opposé à celui de la portion 28, par exemple dopée de type P. La couche de blocage d'électrons 40 peut être de même type de conductivité que la couche semiconductrice 42.

Les portions isolantes 34 sont adaptées à empêcher la formation d'un contact électrique direct entre la portion inférieure 26 de chaque fil 24 et l'électrode 38. Les portions isolantes 34 peuvent être déposées de façon conforme, par exemple par CVD. Les portions isolantes 34 peuvent être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxyde d'aluminium (Al₂O₃), en oxyde d'hafnium (HfO₂) ou en diamant.

Les portions réfléchissantes 36 sont réalisées, par exemple, en aluminium, en argent ou en ruthénium et ont, par exemple, une épaisseur supérieure à 100 nm.

La deuxième électrode 38 est adaptée pour à la fois polariser la couche active 30 de chaque fil 24 et laisser passer le rayonnement électromagnétique émis ou reçu par les fils 24. Le matériau formant l'électrode 38 peut être un matériau transparent, et conducteur tel que de l'oxyde d'indium-étain (ou ITO, acronyme anglais pour Indium Tin Oxide), de l'oxyde de zinc dopé à l'aluminium ou du graphène.

Dans le présent mode dé réalisation, les fils 24 sont réalisés sur des îlots 18 qui sont des éléments séparés répartis sur le substrat 14. Si les fils étaient formés sur une couche recouvrant le substrat 14, le fait que la couche et le substrat 14 soient constitués de matériaux différents ayant des coefficients de dilatation thermique différents entraînerait l'apparition de contraintes mécaniques dans le dispositif optoélectronique au cours de sa fabrication. Le présent mode de réalisation permet avantageusement d'éviter l'apparition de contraintes mécaniques dans les îlots 18 et le substrat 14 en raison de la différence de coefficients de dilatation thermique entre les matériaux constituant les îlots 18 et le substrat 14.

Si les flancs latéraux 21 des îlots de germination 18 n'étaient pas recouverts d'un matériau impropre à la croissance de fils, ils constitueraient des sites de croissance préférentiels. La présence de flancs latéraux 21 libres pourrait alors donner lieu à des croissances parasites, par exemple la croissance de plusieurs fils sur les flancs latéraux 21 en plus du fil sur la face 20, ou la croissance de fils dont l'axe serait non perpendiculaire à la face 20 de l'îlot de germination 18. Dans le présent mode de réalisation, comme les flancs 21 des îlots de germination 18 sont recouverts d'un matériau impropre à la croissance de fils, la croissance des fils 24 a seulement lieu depuis le sommet 20 de chaque îlot 18. Les risques de croissance de un ou plusieurs fils 24 dans des directions différentes à la normale à la face 20 depuis un même îlot 18 sont donc réduits.

Les figures 4A à 4I illustrent les structures obtenues à des étapes successives d'un mode de réalisation d'un procédé de fabrication du dispositif optoélectronique 10 de la figure 3.

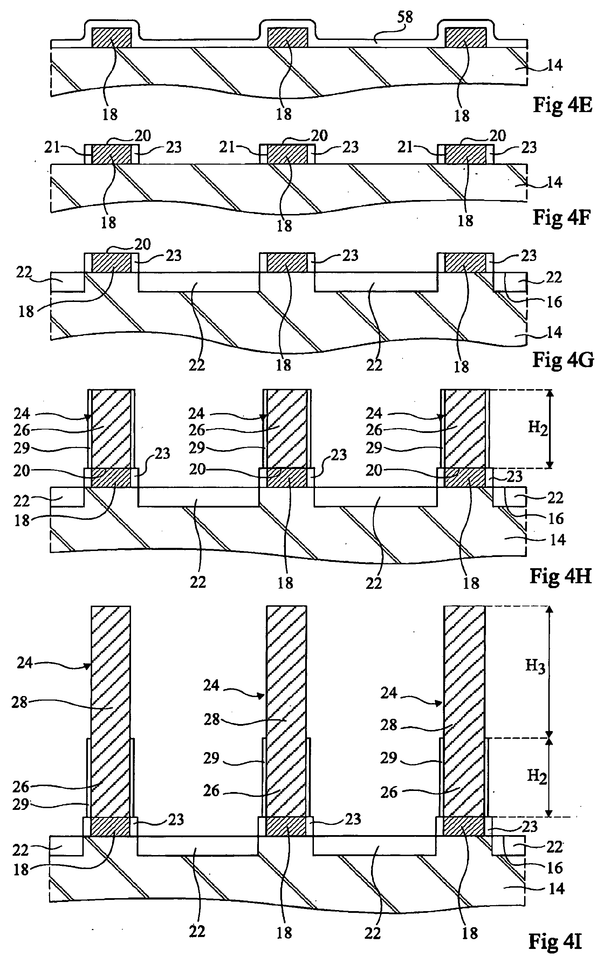

Le mode de réalisation du procédé de fabrication selon l'invention comprend les étapes suivantes :
(1) Dépôt sur le substrat 14 d'une couche 50 uniforme du matériau favorisant la croissance du composé III-N, par exemple selon la polarité N (figure 4A). Il peut s'agir de nitrure d'aluminium. La couche 50 a, par exemple, une épaisseur comprise entre 1 nm et 100 nm, de préférence entre 10 nm et 60 nm. La couche 50 peut être obtenue par un procédé du type MOCVD. Toutefois, des procédés tels que CVD, MBE, GSMBE, MOMBE, ALE, HVPE, ALD (acronyme anglais pour Atomic Layer Deposition), l'évaporation ou la pulvérisation cathodique réactive peuvent être utilisés ou tout type de dépôt permettant l'obtention d'une couche texturée. Lorsque la couche 50 est en nitrure d'aluminium, la couche 50 doit être sensiblement texturée et posséder une polarité préférentielle. La texturation de la couche 50 peut être obtenue par un traitement supplémentaire réalisé après le dépôt de la couche 50. Il s'agit, par exemple, d'un recuit sous flux d'ammoniac (NH₃).
(2) Dépôt d'une couche 51 d'un matériau diélectrique sur la couche 50 (figure 4B). La couche 51 est en un matériau diélectrique qui peut être gravé de façon sélective par rapport au matériau formant la couche 50. Le matériau diélectrique est, par exemple, du nitrure de silicium (par exemple Si₃N₄). La couche diélectrique 51 a, par exemple, une épaisseur comprise entre 50 et 300 nm, par exemple environ 100 nm.
(3) Gravure d'ouvertures 54 dans la couche diélectrique 51 pour former des portions 52, ou blocs, de la couche diélectrique 51 et exposer des zones de la couche 50 et gravure d'ouvertures 56 dans la couche 50 au niveau des parties exposées de la couche 50 pour former les îlots 18 (figure 4C). La gravure des ouvertures 54 peut être réalisée par une étape de gravure sélective qui n'entraîne pas de gravure de la couche 50. Il peut s'agir d'une gravure utilisant un plasma d'hexafluorure de soufre (SF₆). La gravure des ouvertures 56 peut correspondre à une gravure sèche ou humide avec arrêt sur/dans le substrat 14. A titre d'exemple, la gravure des ouvertures 56 peut être une gravure ionique réactive ou RIE (sigle anglais pour Reactive Ion Etching), une gravure au plasma couplé par induction ou gravure ICP (sigle anglais pour Inductively Coupled Plasma) ou une gravure humide.
(4) Retrait des portions 52 (figure 4D). Le retrait des portions 52 de la couche de diélectrique peut être réalisé par une étape de gravure sélective qui n'entraîne pas de gravure des plots 18 et du substrat 14. Il peut s'agir d'une gravure utilisant un plasma d'hexafluorure de soufre (SF₆) ou un plasma chloré, ou d'une gravure humide de type BOE (acronyme anglais pour Buffered Oxide Etch) utilisant un mélange de fluorure d'ammonium (NH₄F) et d'acide fluorhydrique (HF).
(5) Dépôt d'une couche 58 d'un matériau impropre à la croissance de fils, par exemple un matériau diélectrique, sur les îlots 18 et sur le substrat 14 (figure 4E). Il s'agit, de préférence, d'un dépôt conforme ou sensiblement conforme. La couche 58 est en un matériau qui peut être gravé de façon sélective par rapport au matériau constituant les îlots 18 et le substrat 14. La couche 58 est, par exemple, en nitrure de silicium (par exemple Si₃N₄), en oxyde de silicium (SiO₂) ou en un siliciure des matériaux décrits précédemment pour la réalisation des îlots de germination 18. La couche 58 a, par exemple, une épaisseur au moins égale à un tiers de l'épaisseur des îlots de germination 18, et, en particulier, une épaisseur comprise entre 5 nm et 200 nm, par exemple égale à environ 100 nm.
(6) Gravure anisotrope de la couche 58 pour retirer les parties de la couche 58 recouvrant le substrat 14 et les sommets 20 des îlots 18 et conserver les parties 23 de la couche 58 recouvrant les flancs latéraux 21 des îlots 18 (figure 4F). Il s'agit d'une gravure sélective par rapport au matériau constituant le substrat 14 et au matériau constituant les îlots de germination 18. Il s'agit, par exemple, d'une gravure ionique ou d'une gravure par ions réactifs.
(7) Formation de la région 22 par un procédé de nitruration des zones exposées du substrat 14 (figure 4G) non recouvertes par les îlots 18. La région 22 est essentiellement constituée de nitrure de silicium. La profondeur de nitrure de silicium obtenue doit être suffisante pour prévenir toute attaque de l'élément du groupe III, par exemple le gallium, contre le matériau constituant le substrat 14. La profondeur de la région 22 peut être comprise entre 5 nm et 100 nm, de préférence supérieure ou égale à 10 nm. La région 22 peut s'étendre en partie sous les îlots 18. Les conditions de nitruration sont choisies de façon que le substrat 14 reste néanmoins en contact électrique avec chaque îlot 18. En outre, une surépaisseur peut apparaître au niveau de la région 22. L'étape de nitruration peut être réalisée avec de l'ammoniac dans un four dédié ou dans un réacteur d'épitaxie. La température de nitruration peut varier de 900 à 1100 °C et la durée de nitruration peut varier de quelques minutes à une heure. On obtient, en outre, une nitruration des sommets 20 des îlots 18 favorables à la croissance ultérieure des portions inférieures 26 des fils 24. Le procédé de nitruration peut être réalisé en plusieurs étapes. A titre d'exemple, notamment lorsque les îlots sont en aluminium (éventuellement dopé au silicium), l'étape de nitruration peut comprendre une première phase de nitruration réalisée à une première température, par exemple comprise entre 400 et 750 °C, suivie d'une deuxième phase de nitruration réalisée à une deuxième température strictement supérieure à la première température, par exemple comprise entre 800 et 1100 °C. La première phase favorise la nitruration du sommet 20 de chaque îlot 18 tandis que la deuxième phase favorise la nitruration des parties du substrat 14 non recouvertes par les îlots 18.
(8) Croissance de la portion passivée 26 de chaque fil 24 sur la hauteur H₂ (figure 4H). Chaque fil 24 croît depuis la face 20 au sommet d'un îlot de germination 18. La portion inférieure 26 de chaque fil 24 peut être obtenue par un procédé du type MOCVD. Toutefois, des procédés tels que CVD, MBE, GSMBE, MOMBE, PAMBE, ALE, HVPE, ou électro-chimiques peuvent être utilisés.
   A titre d'exemple, dans le cas où la portion inférieure 26 est en GaN fortement dopée de type N, un procédé du type MOCVD peut être mis en oeuvre par injection dans un réacteur MOCVD, de type douchette, d'un gaz précurseur du gallium, par exemple le triméthylgallium (TMGa) et d'un gaz précurseur de l'azote, par exemple l'ammoniac (NH₃). A titre d'exemple, on peut utiliser un réacteur MOCVD 3x2", de type douchette, commercialisé par la société AIXTRON. Un rapport de flux moléculaires entre le triméthylgallium et l'ammoniac dans la .gamme 5-200, de préférence dans la gamme 10-100, permet de favoriser la croissance de fils. A titre d'exemple, un gaz porteur qui assure la diffusion des organométalliques jusque dans le réacteur vient se charger en organométalliques dans un bulleur de TMGa. Celui-ci est réglé selon les conditions standard de fonctionnement. Un flux de 60 sccm (centimètres cubes standard par minute) est, par exemple choisi pour le TMGa, tandis qu'un flux de 300 sccm est utilisé pour le NH₃ (bouteille standard de NH₃). On utilise une pression d'environ 800 mbar (800 hPa). Le mélange gazeux comprend, en outre, l'injection de silane dans le réacteur MOCVD, matériau précurseur du silicium. Le silane peut être dilué dans de l'hydrogène à 1000 ppm et l'on apporte un flux de 20 sccm. La température dans le réacteur est, par exemple, comprise entre 950 °C et 1100 °C, de préférence entre 990°oet 1060 °C. Pour transporter les espèces de la sortie des bulleurs aux deux plénums du réacteur, on utilise un flux de gaz porteur, par exemple du N₂, de 2000 sccm réparti dans les deux plénums. Les flux de gaz indiqués précédemment sont donnés à titre indicatif et sont à adapter en fonction de la taille et des spécificités du réacteur.
   La présence de silane parmi les gaz précurseurs entraîne l'incorporation de silicium au sein du composé GaN. En outre, ceci se traduit par la formation de la couche 29 de nitrure de silicium qui recouvre le pourtour de la portion 26 de hauteur H₂, à l'exception du sommet au fur et à mesure de la croissance de la portion 26.
(9) Croissance de la portion supérieure 28 de hauteur H₃ de chaque fil 24 (figures 4I) sur le sommet de la portion inférieure 26. Pour la croissance de la portion supérieure 28, les conditions de fonctionnement du réacteur MOCVD décrites précédemment sont, à titre d'exemple, maintenues à l'exception du fait que le flux de silane dans le réacteur est réduit, par exemple d'un facteur supérieur ou égal à 10, ou arrêté. Même lorsque le flux de silane est arrêté, une portion active peut être dopée de type N en raison de la diffusion dans cette portion active de dopants provenant des portions passivées adjacentes ou en raison du dopage résiduel du GaN.

Le procédé comprend les étapes supplémentaires suivantes :
(10) Formation, pour chaque fil 24, de la couche active 30 par épitaxie. Compte tenu de la présence de la portion passivante 23 sur les flancs latéraux 21 de l'îlot de germination 18 et de la portion passivante 29 recouvrant le pourtour de la portion inférieure 26, le dépôt de la couche active 30 ne se produit que sur la portion supérieure 28 du fil 24 ;
(11) Formation par épitaxie, pour chaque fil 24, de la couche de blocage d'électrons 40 et de la couche semiconductrice 42 ;
(12) Formation des portions isolantes 34. Les portions isolantes 34 peuvent être formées par le dépôt conforme d'une couche isolante sur la totalité de la structure, le dépôt d'une couche de résine entre les fils 24, la gravure de la couche isolante non recouverte par la résine pour découvrir la couche semiconductrice 42 et le retrait de la résine.
(13) Formation des portions réfléchissantes 36 ; et
(14) Formation des électrodes 38 et 12.

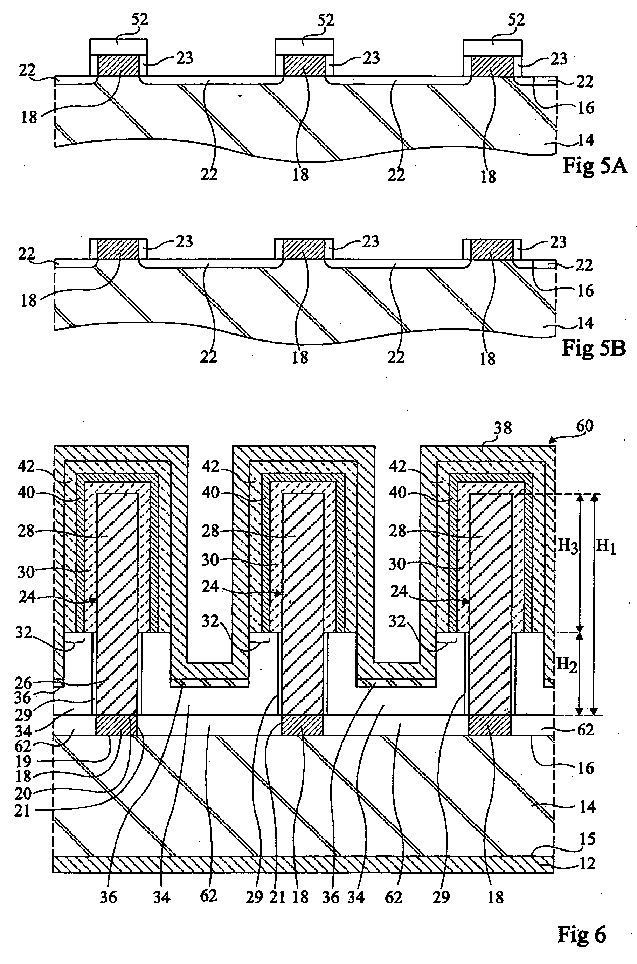

Les figures 5A et 5B illustrent des étapes (4)' et (5)' d'un autre mode de réalisation d'un procédé de fabrication du dispositif optoélectronique 10 représenté en figure 3 et remplacent les étapes (4) à (7) décrites précédemment en relation avec les figures 4D à 4G, les autres étapes (1) à (3) et (8) à (14) étant identiques à celles décrites précédemment. Les étapes (4)' et (5)' sont les suivantes :
(4)' Formation des portions 23 et de la région 22 par un procédé d'oxydation thermique des zones exposées du substrat 14 et des îlots de germination 18 (figure 5A). Les portions 23 sont essentiellement en oxyde des matériaux constituant les îlots de germination 18 décrits précédemment. La région 22 est essentiellement constituée de dioxyde de silicium (SiO₂) et lorsque les îlots de germination 18 sont en nitrure d'aluminium, les portions 23 sont essentiellement en oxyde d'aluminium. La profondeur de la région 22 d'oxyde de silicium obtenue doit être suffisante pour prévenir toute attaque de l'élément du groupe III, par exemple le gallium, contre le matériau constituant le substrat 14. La profondeur de la région 22 peut être comprise entre 5 nm et 100 nm, de préférence supérieure ou égale à 10 nm. Les portions 23 ont une épaisseur comprise entre 5 nm et 100 nm, par exemple égale à environ 10 nm.
   La région diélectrique 22 et les portions diélectriques 23 peuvent être réalisées dans un four à haute température. L'étape d'oxydation peut être réalisée avec de l'oxygène ou avec de la vapeur d'eau. A titre d'exemple, la température d'oxydation varie de 750 à 1100 °C pour des durées d'oxydation variant de quelques minutes à une heure. Lors de l'étape de formation de la région 22 et des portions 23, les portions 52 protègent le sommet 20 de chaque îlot 18 contre le traitement d'oxydation. La région 22 peut s'étendre en partie sous les îlots 18. Les conditions d'oxydation sont choisies de façon que le substrat 14 reste néanmoins en contact électrique avec chaque îlot 18. En outre, une surépaisseur peut apparaître au niveau de la région 22.
(5)' Retrait des portions 52 de la couche de diélectrique 51 (figure 5B). Le matériau constituant les portions 52 est choisi pour pouvoir être gravé de façon sélective par rapport aux matériaux constituant les îlots de germination 18, la région diélectrique 22 et les portions diélectriques 23. A titre d'exemple, le matériau constituant les portions 52 est du nitrure de silicium. Ceci peut être réalisé par une étape de gravure sélective qui n'entraîne pas de gravure des plots 18, des portions 23 et des régions 22. Il peut s'agir d'une gravure utilisant un plasma d'hexafluorure de soufre (SF₆).

La figure 6 est une coupe, partielle et schématique, d'un autre mode de réalisation d'un dispositif optoélectronique 60, ne faisant par partie de la présente invention, réalisé à partir de fils 24 tels que décrits précédemment et adapté à l'émission d'un rayonnement électromagnétique. Le dispositif 60 diffère du dispositif 10 en ce que les régions isolantes 22 s'étendant dans le substrat 14 et les portions de protection 23 sur les flancs latéraux 21 des îlots de germination 18 du dispositif 10 sont remplacées par une zone isolante 62 formée sur la face 16 du substrat 14 et s'étendant entre les îlots 18 jusqu'au contact des flancs latéraux 21 des îlots 18. Le matériau diélectrique constituant la zone isolante 62 est, par exemple, du nitrure de silicium (par exemple Si₃N₄). La zone isolante 62 a, par exemple, sensiblement la même hauteur que les îlots de germination 18.

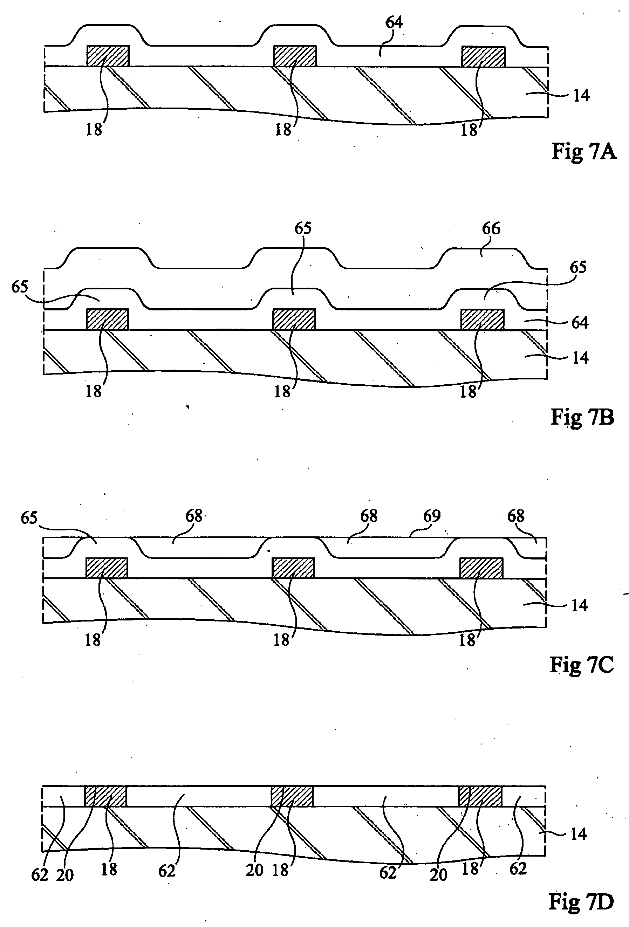

Les figures 7A à 7D illustrent des étapes (5)", (6)", (7)" et (8)" d'un mode de réalisation d'un procédé, ne faisant par partie de la présente invention, de fabrication du dispositif 60 et remplacent les étapes (5) à (7) décrites précédemment en relation avec les figures 4E à 4G, les autres étapes (1) à (4) et (8) à (14) étant identiques à celles décrites précédemment. Les étapes (5)", (6)", (7)" et (8)" sont les suivantes :
(5)" Dépôt d'une couche 64 d'un premier matériau diélectrique sur le substrat 14 et sur les îlots de germination 18 (figure 7A). La couche 64 est en un premier matériau diélectrique qui peut être gravé de façon sélective par rapport au matériau formant les îlots de germination 18. Le premier matériau diélectrique est, par exemple, de l'oxyde de silicium ou du nitrure de silicium. La couche diélectrique 64 a, de préférence, une épaisseur strictement supérieure ou égale à l'épaisseur des îlots de germination 18, de préférence supérieure ou égale à au moins 1,5 fois l'épaisseur des îlots de germination 18. A titre d'exemple, la couche 64 a une épaisseur comprise entre 1 nm et 100 nm, par exemple environ 60 nm. La couche 64 est, par exemple, déposée de façon conforme. La couche 64 forme donc une bosse 65 sur chaque îlot de germination 18.
(6)" Dépôt d'une couche 66 d'un deuxième matériau diélectrique sur la couche 64 (figure 7B). Le deuxième matériau diélectrique est différent du premier matériau diélectrique. Toutefois, le deuxième matériau diélectrique est choisi de façon qu'il existe un procédé de gravure qui permette de graver de façon non sélective les premier et deuxième matériaux diélectriques, sensiblement à la même vitesse. Le deuxième matériau diélectrique est, par exemple, de l'oxyde de silicium lorsque le premier matériau diélectrique est du nitrure de silicium ou du nitrure de silicium lorsque le premier matériau diélectrique est de l'oxyde de silicium. La couche diélectrique 66 a une épaisseur strictement supérieure à l'épaisseur de la couche de diélectrique 64, de préférence supérieure ou égale à au moins 1,5 fois l'épaisseur de la couche 64, plus préférentiellement égale ou supérieure à trois fois l'épaisseur de la couche 64. A titre d'exemple, la couche 66 a une épaisseur comprise entre 50 et 200 nm, par exemple environ 100 nm. La couche 66 est, par exemple, déposée de façon conforme.
(7)" Gravure de la couche 66 jusqu'à exposer des portions de la couche 64 (figure 7C). La gravure peut être une gravure mécano-chimique ou CMP (acronyme anglais pour Chemical-Mechanical Planarization). L'arrêt de gravure peut être réalisé dès que la couche 64 commence à être visible par une inspection optique étant donné que les premier et deuxième matériaux diélectriques sont différents. A la fin de la gravure, des portions 68 de la couche 66 sont laissées entre les bosses 65 de la couche 64. La structure obtenue après cette étape de gravure a une face supérieure 69 sensiblement plane.
(8)" Gravure des portions restantes 68 de la couche 66 et de la couche 64 jusqu'à exposer les sommets 20 des îlots de germination 18 (figure 7D). La gravure est une gravure sélective par rapport au matériau constituant les îlots de germination 18. Il peut s'agir d'une gravure par plasma ou d'une gravure humide. L'arrêt de gravure peut être réalisé lorsque les sommets 20 des îlots de germination 18 sont visibles par une inspection optique étant donné que le matériau constituant les îlots de germination 18 est différent du premier matériau diélectrique. En figure 7D, à la fin de l'étape de gravure, les portions 6 restantes de la couche 66 ont sensiblement disparu. Toutefois, à titre de variante, lors de l'arrêt de gravure, il peut rester des portions 68 de la couche 66 entre les plots 18.

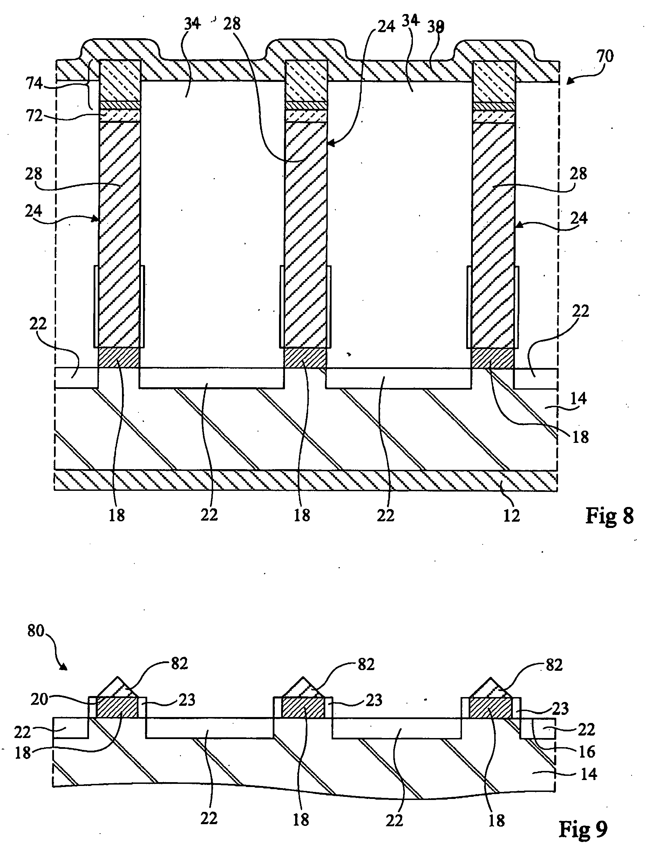

La figure 8 est une coupe, partielle et schématique, d'un autre mode de réalisation, conformément à la présente invention, d'un dispositif optoélectronique 70 qui est adapté pour émettre un rayonnement électromagnétique. Le dispositif 70 diffère du dispositif 10 notamment par la forme de la portion active de chaque fil 24. En effet, pour chaque fil 24, la portion active 72 recouvre seulement le sommet du fil 24. La portion active 72 peut avoir la même composition que la couche active 30 décrite précédemment. En outre, un empilement de portions semiconductrices 74 recouvre la portion active 72. L'empilement de couches semiconductrices 74 peut avoir la même composition que l'empilement 32 décrit précédemment.

La figure 9 est une coupe, partielle et schématique, d'un mode de réalisation d'un dispositif optoélectronique 80 à éléments tridimensionnels pyramidaux, conformément à la présente invention, à une étape de fabrication qui suit l'étape illustrée à la figure 4G. On fait croître des éléments tridimensionnels 82, par exemple de forme conique ou tronconique à base polygonale, en particulier de forme pyramidale ou pyramidale tronquée. A titre d'exemple, lorsque les éléments tridimensionnels comprennent majoritairement un composé III-V, le matériau constituant les îlots de germination 18 est choisi de préférence de façon à favoriser la croissance du composé III-V selon la polarité de l'élément du groupe III.

Des modes de réalisation particuliers de la présente invention ont été décrits. Diverses variantes et modifications apparaîtront à l'homme de l'art. En particulier, bien qu'on ait représenté sur les figures des modes de réalisation dans lesquels les fils, recouverts d'une première électrode, sont formés sur une première face d'un support tandis qu'une deuxième électrode est formée sur une deuxième face du support, opposée à la première face, il est clair toutefois que la deuxième électrode peut être prévue du côté de la première face.

De plus, bien que, dans les modes de réalisation décrits précédemment, chaque fil 24 comprenne une portion passivée 26, à la base du fil en contact avec le sommet 20 d'un îlot de germination 18, cette portion passivée 26 peut ne pas être présente.

De plus, si les différents modes de réalisation de dispositifs optoélectroniques décrits précédemment sont adaptés pour émettre un rayonnement électromagnétique, de tels dispositifs peuvent aisément être adaptés par un homme du métier pour recevoir un rayonnement électromagnétique et le convertir en un signal électrique. La couche active 30 est alors la couche dans laquelle est capturée la majorité du rayonnement reçu par le dispositif. Une telle adaptation est réalisée en adaptant à la fois la couche active 30, 72 de chacun des fils 24 et en appliquant sur la structure semiconductrice une polarisation adéquate. Une telle adaptation du dispositif 10, 70 peut être réalisée pour former soit un dispositif optoélectronique dédié à la mesure ou la détection d'un rayonnement électromagnétique, soit un dispositif optoélectronique dédié aux applications photovoltaïques.

## Revendications

1. Dispositif optoélectronique (10 ; 70 ; 80), comprenant :
un substrat (14) ;
des plots (18) sur une face (16) du substrat ;
des éléments semiconducteurs (24 ; 82), chaque élément reposant sur un plot ;
une portion (23) recouvrant au moins les flancs latéraux (21) de chaque plot, ladite portion empêchant la croissance des éléments semiconducteurs sur les flancs latéraux ; et **caractérisé par**, en outre,
une région (22) diélectrique s'étendant dans le substrat (14) depuis ladite face (16) et reliant, pour chaque paire de plots (18), l'un des plots de la paire à l'autre plot de la paire.

2. Dispositif optoélectronique selon la revendication 1, dans lequel le substrat (14) est en un premier matériau semiconducteur choisi parmi le groupe comprenant le silicium, le germanium, le carbure de silicium, un composé III-V, un composé II-VI et une combinaison de ces composés.

3. Dispositif optoélectronique selon la revendication 2, dans lequel chaque élément (24 ; 82) comprend au moins une partie (26, 28) comprenant majoritairement un deuxième matériau semiconducteur en contact avec l'un des plots (18), le deuxième matériau semiconducteur étant choisi parmi le groupe comprenant le silicium, le germanium, le carbure de silicium, un composé III-V, un composé II-VI et une combinaison de ces composés.

4. Dispositif optoélectronique selon l'une quelconque des revendications 1 à 3, dans lequel l'épaisseur de chaque plot (18) est comprise entre 1 nm et 100 nm et dans lequel le substrat (14) est en contact électrique avec chaque plot (18).

5. Dispositif optoélectronique selon l'une quelconque des revendications 1 à 4, dans lequel chaque élément (24 ; 82) est un microfil, un nanofil, un élément conique ou un élément tronconique.

6. Dispositif optoélectronique selon l'une quelconque des revendications 1 à 5, dans lequel la portion (23) est en un matériau isolant.

7. Procédé de fabrication d'un dispositif optoélectronique (10 ; 70 ; 80), comprenant les étapes successives suivantes :
prévoir un substrat (14) ;
former des plots (18) sur une face (16) du substrat ;
former une portion (23) recouvrant au moins les flancs latéraux (21) de chaque plot et former une région (22) diélectrique s'étendant dans le substrat (14) depuis ladite face (16) et reliant, pour chaque paire de plots (18), l'un des plots de la paire à l'autre plot de la paire ; et
former des éléments semiconducteurs (24 ; 82), chaque élément reposant sur un plot, ladite portion comprenant un matériau empêchant la croissance des éléments semiconducteurs sur les flancs latéraux.

8. Procédé selon la revendication 7, dans lequel la portion (23) est en un matériau isolant.

9. Procédé selon la revendication 7 ou 8, dans lequel la région (22) est formée par oxydation ou nitruration du substrat (14).

10. Procédé selon la revendication 9, comprenant les étapes successives suivantes :
dépôt d'une couche (50) sur le substrat (14) ;
formation de blocs isolants (52) sur la couche (50) ;
gravure des parties de la couche non recouvertes des blocs isolants pour former les plots (18) ;
oxydation des flancs (21) des plots et des parties du substrat non recouvertes des plots ; et
retrait des blocs isolants.

11. Procédé selon la revendication 9, comprenant les étapes successives suivantes :
dépôt d'une couche (50) sur le substrat (14) ;
formation de blocs isolants (52) sur la couche (50) ;
gravure des parties de la couche non recouvertes des blocs isolants pour former les plots (18) ;
retrait des blocs isolants ;
dépôt d'une couche diélectrique (58) recouvrant les plots et le substrat entre les plots ;
gravure anisotrope de la couche diélectrique pour retirer la couche diélectrique sur le substrat et au sommet des plots et laisser les portions (23) de la couche diélectrique sur les flancs latéraux (21) ; et
nitruration des parties du substrat non recouvertes des plots, et éventuellement des sommets des plots (18).

## Patentansprüche

1. Eine optoelektronische Vorrichtung (10; 70; 80), die folgendes aufweist:
ein Substrat (14);
Kontakte (18) auf einer Oberfläche (16) des Substrats;
Halbleiterelemente (24; 82), deren jedes auf einem Kontakt sich befindet;
der Teil (23), der mindestens die seitlichen Seiten (21) jedes Kontakts abdeckt, wobei der erwähnte Teil das Wachstum der Halbleiterelemente an den seitlichen Seiten verhindert; und ferner **gekennzeichnet durch**
einen dielektrischen Bereich (22), der sich in dem Substrat (14) von der erwähnten Oberfläche (16) erstreckt und für jedes Paar von Kontakten (18) einen der Kontakte in dem Paar mit dem anderen Kontakt in dem Paar verbindet.

2. Optoelektronische Vorrichtung nach Anspruch 1, wobei das Substrat (14) aus einem ersten Halbleitermaterial hergestellt ist, und zwar ausgewählt aus der Gruppe, die Silizium, Germanium, Siliziumkarbid, eine III-V-Verbindung, eine II-VI-Verbindung und eine Kombination dieser Verbindungen enthält.

3. Optoelektronische Vorrichtung nach Anspruch 2, wobei jedes Element (24; 82) mindestens einen Teil (26, 28) aufweist, der hauptsächlich ein zweites Halbleitermaterial in Kontakt mit einem der Kontakte (18) aufweist, wobei das zweite Halbleitermaterial ausgewählt ist aus der Gruppe, die folgendes aufweist: Silizium, Germanium, Siliziumkarbid, eine III-V-Verbindung, eine II-VI-Verbindung und eine Kombination aus diesen Verbindungen.

4. Optoelektronische Vorrichtung nach einem der Ansprüche 1 bis 3, wobei die Dicke jedes Kontakts (18) im Bereich von 1 nm bis 100 nm liegt, und wobei das Substrat (14) in elektrischem Kontakt mit jedem Kontakt (18) steht.

5. Optoelektronische Vorrichtung nach einem der Ansprüche 1 bis 4, wobei jedes Element (24; 82) ein Mikrodraht, ein Nanodraht, ein konisches Element oder ein verjüngtes Element ist.

6. Optoelektronische Vorrichtung nach einem der Ansprüche 1 bis 5, wobei der Teil (23) aus einem Isolationsmaterial hergestellt ist.

7. Ein Verfahren zur Herstellung einer optoelektronischen Vorrichtung (10; 70; 80), wobei die folgenden aufeinanderfolgenden Schritte vorgesehen sind:
Vorsehen eines Substrats (14);
Formen von Kontakten (18) auf einer Oberfläche (16) des Substrats;
Formen eines Teils (23), der mindestens die seitlichen Seiten (21) jedes Kontakts abdeckt und Formen eines dielektrischen Bereichs (22), der sich in dem Substrat (14) erstreckt, und zwar von der erwähnten Oberfläche (16) und der für jedes Paar von Kontakten (18) einen der Kontakte in dem Paar mit dem anderen Kontakt in dem Paar verbindet; und
Formen von Halbleiterelementen (24; 82), deren jedes auf einem Kontakt ruht, wobei der erwähnte Teil ein Material aufweist, welches das Wachstum der Halbleiterelemente auf den seitlichen Seiten verhindert.

8. Das Verfahren nach Anspruch 7, wobei der Teil (23) aus einem Isoliermaterial hergestellt ist.

9. Das Verfahren nach Anspruch 7 oder 8, wobei der Bereich (22) durch Oxidation oder Nitrierung des Substrats (14) gebildet ist.

10. Das Verfahren nach Anspruch 9, wobei die folgenden aufeinanderfolgenden Schritte vorgesehen sind:
Abscheiden einer Schicht (50) auf dem Substrat (14);
Formen von Isolierblöcken (52) auf der Schicht (50);
Ätzen der Teile der Schicht, die nicht mit den Isolierblöcken abgedeckt sind, um die Kontakte (18) zu formen;
Oxidieren der Seiten (21) der Kontakte und der Substratteile, die nicht mit den Kontakten abgedeckt sind; und
Entfernen der Isolierblöcke.

11. Das Verfahren nach Anspruch 9, wobei die aufeinanderfolgenden Schritte vorgesehen sind:
Abscheiden einer Schicht (50) auf dem Substrat (14);
Formen von Isolierblöcken (52) auf der Schicht (50);
Ätzen der Teile der Schicht, die nicht mit Isolierblöcken bedeckt sind, um die Kontakte (18) zu formen;
Entfernen der Isolierblöcke;
Abscheiden einer dielektrischen Schicht (58), die Kontakte und das Substrat zwischen den Kontakten abdeckt;
anisotropes Ätzen der dielektrischen Schicht zur Entfernung der dielektrischen Schicht von dem Substrat und von der Oberseite der Kontakte und Zurücklassen von Teilen (23) der dielektrischen Schicht auf den seitlichen Seiten (21); und
Nitrieren der Substratteile, die nicht mit den Kontakten abgedeckt sind, und möglicherweise der Oberseiten der Kontakte (18).

## Claims

1. An optoelectronic device (10; 70; 80) comprising:
a substrate (14);
pads (18) on a surface (16) of the substrate;
semiconductor elements (24; 82), each element resting on a pad;
a portion (23) covering at least the lateral sides (21) of each pad, said portion preventing the growth of the semiconductor elements on the lateral sides; and further **characterized by**
a dielectric region (22) extending in the substrate (14) from said surface (16) and connecting, for each pair of pads (18), one of the pads in the pair to the other pad in the pair.

2. The optoelectronic device of claim 1, wherein the substrate (14) is made of a first semiconductor material selected from the group comprising silicon, germanium, silicon carbide, a III-V compound, a II-VI compound, and a combination of these compounds.

3. The optoelectronic device of claim 2, wherein each element (24; 82) comprises at least a portion (26, 28) mainly comprising a second semiconductor material in contact with one of the pads (18), the second semiconductor material being selected from the group comprising silicon, germanium, silicon carbide, a III-V compound, a II-VI compound, and a combination of these compounds.

4. The optoelectronic device of any of claims 1 to 3, wherein the thickness of each pad (18) is in the range from 1 nm to 100 nm and wherein the substrate (14) is in electric contact with each pad (18).

5. The optoelectronic device of any of claims 1 to 4, wherein each element (24; 82) is a microwire, a nanowire, a conical element, or a tapered element.

6. The optoelectronic device of any of claims 1 to 5, wherein the portion (23) is made of an insulating material.

7. A method of manufacturing an optoelectronic device (10; 70; 80) comprising the successive steps of:
providing a substrate (14);
forming pads (18) on a surface (16) of the substrate;
forming a portion (23) covering at least the lateral sides (21) of each pad and forming a dielectric region (22) extending in the substrate (14) from said surface (16) and connecting, for each pair of pads (18), one of the pads in the pair to the other pad in the pair; and
forming semiconductor elements (24; 82), each element resting on a pad, said portion comprising a material preventing the growth of the semiconductor elements on the lateral sides.

8. The method of claim 7, wherein the portion (23) is made of an insulating material.

9. The method of claim 7 or 8, wherein the region (22) is formed by oxidation or nitriding of the substrate (14).

10. The method of claim 9, comprising the successive steps of:
depositing a layer (50) on the substrate (14);
forming insulating blocks (52) on the layer (50);
etching the portions of the layer which are not covered with the insulating blocks to form the pads (18);
oxidizing the sides (21) of the pads and the substrate portions which are not covered with the pads; and
removing the insulating blocks.

11. The method of claim 9, comprising the successive steps of:
depositing a layer (50) on the substrate (14);
forming insulating blocks (52) on the layer (50);
etching the portions of the layer which are not covered with the insulating blocks to form the pads (18);
removing the insulating blocks;
depositing a dielectric layer (58) covering the pads and the substrate between the pads;
anisotropically etching the dielectric layer to remove the dielectric layer from the substrate and from the top of the pads and leave portions (23) of the dielectric layer on the lateral sides (21); and
nitriding the substrate portions which are not covered with the pads, and possibly the tops of the pads (18).
